# EUROPEAN PATENT APPLICATION

(11) **EP 3 041 030 A1**
(43) Date of publication of application: **06.07.2016**
(21) Application number: 14839637.7
(22) Date of filing: 20.08.2014
(51) Int. Cl.: H01L 21/225, H01L 31/068

(54) **COMPOSITION FOR FORMING N-TYPE DIFFUSION LAYER, METHOD FOR FORMING N-TYPE DIFFUSION LAYER, METHOD FOR PRODUCING SEMICONDUCTOR SUBSTRATE WITH N-TYPE DIFFUSION LAYER, AND METHOD FOR MANUFACTURING SOLAR CELL ELEMENT**

(30) Priority: 30.08.2013 JP 2013179852
(71) Applicant: Hitachi Chemical Company, Ltd., Chiyoda-ku Tokyo 100-6606 (JP)
(72) Inventor: SATO, Tetsuya, Tokyo 100-6606 (JP); YOSHIDA, Masato, Tokyo 100-6606 (JP); NOJIRI, Takeshi, Tokyo 100-6606 (JP); KURATA, Yasushi, Tokyo 100-6606 (JP); ASHIZAWA, Toranosuke, Tokyo 100-6606 (JP); MACHII, Yoichi, Tokyo 100-6606 (JP); IWAMURO, Mitsunori, Tokyo 100-6606 (JP); ORITA, Akihiro, Tokyo 100-6606 (JP); SHIMIZU, Mari, Tokyo 100-6606 (JP); SATOU, Eiichi, Tokyo 100-6606 (JP)
(74) Representative: Hoffmann Eitle
(86) International application number: PCT/JP2014/071807
(87) International publication number: WO 2015/029858

(57) **Abstract**

A composition for forming an n-type diffusion layer, comprising glass particles that comprise a donor element, a dispersing medium, and an organometallic compound; a method of forming an n-type diffusion layer; a method of producing a semiconductor substrate with an n-type diffusion layer; and a method of producing a photovoltaic cell element.

## Description

### Technical Field

The present invention relates to a composition for forming an n-type diffusion layer, a method of forming an n-type diffusion layer, a method of producing a semiconductor substrate with an n-type diffusion layer, and a method of producing a photovoltaic cell element.

A semiconductor substrate that is used for a photovoltaic cell element or the like has a portion at which a p-type region and an n-type region are in contact with each other (pn junction). Known methods of producing a semiconductor substrate having a pn junction include a method in which a p-type semiconductor substrate is thermally treated in an atmosphere containing a donor element, and the donor element is allowed to diffuse into the semiconductor substrate to form an n-type diffusion layer (a gas phase reaction method) and a method in which a semiconductor substrate is applied with a solution containing a donor element and thermally treated, and the donor element is allowed to diffuse into the semiconductor substrate to form an n-type diffusion layer.

As a gas phase reaction method of forming an n-type diffusion layer, for example, there is a method in which a p-type silicon substrate having a textured surface formed on the light receiving surface, which enhances the efficiency by promoting a light trapping effect, is prepared, and an n-type diffusion layer is uniformly formed on a surface of the p-type silicon substrate by performing a treatment in an atmosphere of a mixed gas of phosphorus oxychloride (POCl₃), nitrogen and oxygen at 800 °C to 900 °C for several tens of minutes.

As a method of forming an n-type diffusion layer with a solution containing a donor element, for example, a method in which a solution containing a phosphate, such as phosphorous pentoxide (P₂O₅) or ammonium dihydrogen phosphate (NH₄H₂PO₄), is applied onto a semiconductor substrate, and thermally treated to diffuse phosphorus into the semiconductor substrate to form an n-type diffusion layer, has been proposed (see, for example, Japanese Patent Application Laid-Open (JP-A) No. 2002-75894).

### SUMMARY OF THE INVENTION

### Technical Problem

In the gas phase reaction method, since diffusion of phosphorus is performed by using a mixed gas, an n-type diffusion layer is formed not only on a surface to be used as a light receiving surface, but also on side surfaces and a back surface. Therefore, it is necessary to perform side etching for removing the n-type diffusion layer formed on the side surfaces. Further, the n-type diffusion layer formed on the back surface needs to be converted to a p⁺-type diffusion layer. In order to convert the n-type diffusion layer to a p⁺-type diffusion layer, a paste containing aluminum is applied onto the n-type diffusion layer at the back surface and thermally treated (sintered) to diffuse aluminum .

Similarly, in the method according to JP-ANo. 2002-75894, phosphorus that vaporizes during the thermal treatment diffuses into side surfaces and a back surface of a semiconductor substrate, and an n-type diffusion layer is formed not only on the light receiving surface of a semiconductor substrate but also on the side surfaces and the back surface. Therefore, processes for removing the n-type diffusion layer on the side surfaces and converting the n-type diffusion layer formed on the back surface into a p⁺-type diffusion layer are necessary. In addition, a phosphate that is used in the method according to JP-A No. 2002-75894 is generally highly hygroscopic. Therefore, there may be a case in which the diffusibility may vary due to moisture absorption of the phosphate in the course of formation of an n-type diffusion layer, and an n-type diffusion layer may not be formed in a stable manner.

The invention was made in view of the problems as set forth above, and aims to provide a composition for forming an n-type diffusion layer that enables stable formation of an n-type diffusion layer at a desired region of a semiconductor substrate, a method of forming an n-type diffusion layer, a method of producing a semiconductor substrate with an n-type diffusion layer, and a method of producing a photovoltaic cell element.

### Means for Solving the Problem

The means for solving the problem are as follows.
<1> A composition for forming an n-type diffusion layer, comprising: glass particles that comprise a donor element; a dispersing medium; and an organometallic compound.
<2> The composition for forming an n-type diffusion layer according to <1>, wherein the organometallic compound comprises a silicon atom.
<3> The composition for forming an n-type diffusion layer according to <1> or <2>, wherein the organometallic compound comprises at least one selected from the group consisting of a metal alkoxide, a silicone resin and an alkylsilazane compound.
<4> The composition for forming an n-type diffusion layer according to any one of <1> to <3>, wherein the organometallic compound comprises a metal alkoxide, and the metal alkoxide comprises a silicon alkoxide.
<5> The composition for forming an n-type diffusion layer according to any one of <1> to <4>, wherein the organometallic compound comprises a metal alkoxide, and the metal alkoxide comprises a silane coupling agent.
<6> The composition for forming an n-type diffusion layer according to <1> or <2>, wherein the organometallic compound comprises a silicone resin.
<7> The composition for forming an n-type diffusion layer according to <6>, wherein the silicone resin comprises dimethyl polysiloxane.
<8> The composition for forming an n-type diffusion layer according to <1> or <2>, wherein the organometallic compound comprises an alkylsilazane compound.
<9> The composition for forming an n-type diffusion layer according to any one of <1> to <8>, wherein the donor element is at least one selected from the group consisting of P (phosphorus) and Sb (antimony).
<10> The composition for forming an n-type diffusion layer according to any one of <1> to <9>, wherein the glass particles comprise at least one donor element-containing substance selected from the group consisting of P₂O₃, P₂O₅ and Sb₂O₃, and at least one glass component substance selected from the group consisting of SiO₂, K₂O, Na₂O, Li₂O, BaO, SrO, CaO, MgO, BeO, ZnO, PbO, CdO, V₂O₅, SnO, ZrO₂ and MoO₃.
<11> A method of forming an n-type diffusion layer, the method comprising a process of applying the composition for forming an n-type diffusion layer according to any one of <1> to <10> onto a semiconductor substrate, and a process of thermally treating the semiconductor substrate applied with the composition for forming an-type diffusion layer.
<12> A method of producing a semiconductor substrate with an n-type diffusion layer, the method comprising a process of applying the composition for forming an n-type diffusion layer according to any one of <1> to <10> onto a semiconductor substrate, and a process of forming an n-type diffusion layer by thermally treating the semiconductor substrate applied with the composition for forming an n-type diffusion layer.
<13> A method of producing a photovoltaic cell element, the method comprising a process of applying the composition for forming an n-type diffusion layer according to any one of <1> to <10> onto a semiconductor substrate, a process of forming an n-type diffusion layer by thermally treating the semiconductor substrate applied with the composition for forming an n-type diffusion layer, and a process of forming an electrode on the n-type diffusion layer.

### Effects of the Invention

According to the invention, a composition for forming an n-type diffusion layer that enables stable formation of an n-type diffusion layer at a desired region of a semiconductor substrate, a method of forming an n-type diffusion layer, a method of producing a semiconductor substrate with an n-type diffusion layer, and a method of producing a photovoltaic cell element are provided.

### BRIEF DESCRIPTION OF DRAWINGS

Figure 1 is a cross-sectional view showing conceptually an example of the method of producing a photovoltaic cell element according to the invention.
Figure 2 shows conceptually an example of the structure of an electrode of the photovoltaic cell element according to the invention, wherein (A) is a plan view seen from the light receiving surface of a photovoltaic cell element, and (B) is an enlarged perspective view showing a part of (A).
Figure 3 is a cross-sectional view showing conceptually an example of a back contact-type photovoltaic cell element.

### DESCRIPTION OF EMBODIMENTS

The term "process" includes herein not only an independent process, but also a process that is not clearly separated from another process, insofar as an intended function of the process can be attained. The numerical range expressed by "x to y" includes the values of x and y as the minimum and maximum values, respectively. When there are plural substances that correspond to the same component, the content of the component refers to the total content of the substances, unless otherwise specified. The term "layer" herein refers to not only a structure formed over the whole surface when observed as a plan view, but also a structure formed only on a part of the same. The term "metal" in an "organometallic compound" and a "metal alkoxide" encompasses a metalloid element, such as silicon. The terms "(meth)acrylic", "(meth)acryloxy", "(meth)acryloyl" and the like refer to either one or both of acrylic and methacrylic, either one or both of acryloxy and methacryloxy, or either one or both of acryloyl and methacryloyl.

### <Composition for forming n-type diffusion layer >

The composition for forming an n-type diffusion layer according to the invention includes glass particles that include a donor element (hereinafter, also simply referred to as "glass particles"), a dispersing medium, and an organometallic compound. The composition may include other additives, as necessary, in view of making the composition easy to apply onto a semiconductor substrate, and the like. In the specification, a composition for forming an n-type diffusion layer refers to a material that includes a donor element and is capable of forming an n-type diffusion layer upon being applied onto a semiconductor substrate and thermally treated to allow the donor element to diffuse into the semiconductor substrate. In an embodiment of the invention, the total of the glass particles, the dispersing medium and the organometallic compound accounts for 50 % by mass or more of the total of the composition for forming an n-type diffusion layer, preferably 70 % by mass or more, more preferably 80 % by mass or more.

In the composition for forming an n-type diffusion layer according to the invention, a donor element is included in the glass particles. Therefore, it is possible to suppress occurrence of a phenomenon that a donor element is vaporized during a thermal treatment and an n-type diffusion layer is formed on a back surface or a side surface of a semiconductor substrate at which the composition is not applied.

Accordingly, in a method in which the composition for forming an n-type diffusion layer according to the invention is used, it is possible to omit a process of performing side etching and a process of converting an n-type diffusion layer formed on a back surface to a p⁺-type diffusion layer, which are essential in the conventional gas phase reaction method, whereby the production method can be simplified. Further, it is possible to minimize the restrictions on the method of forming a p⁺-type diffusion layer on a back surface, and the material, shape, thickness or the like of the back surface electrode, whereby the range of selection of the formation method, the material and the shape are broadened. Further, generation of an internal stress in a semiconductor substrate due to the thickness of a back surface electrode can be suppressed, whereby warpage of the semiconductor substrate can be prevented, as described below.

In the method in which the composition for forming an n-type diffusion layer according to the invention is used, a phenomenon in which a donor element diffuses out of a specific region (out-diffusion) to form an n-type diffusion layer is sufficiently suppressed, whereby an n-type diffusion layer can be formed in a desired pattern, even in a case in which the n-type diffusion layer is formed at a specific region of a semiconductor substrate in a patterned manner.

Whether or not out-diffusion is occurring can be determined by secondary ion mass spectroscopy (SIMS). Specifically, it can be determined by comparing a concentration of a donor element at a region at which an n-type diffusion layer is formed and a concentration of a donor element at a point outside the region at which an n-type diffusion layer is formed (for example, at a point 2 mm away from the outline of the region) by performing SIMS analysis with a SIMS apparatus (for example, trade name IMS-6, Cameca Instruments Japan K.K.)

Further, since the composition for forming an n-type diffusion layer according to the invention includes an organometallic compound, it is considered that the humidity resistance of the glass particles is improved. Namely, it is considered that the humidity resistance of the glass particles is improved because a surface of the glass particles is attached with an organometallic compound by way of physical interaction, chemical interaction or chemical bonding. Improvement in the humidity resistance of the glass particles will result in suppressed elution of a donor element from the glass particles due to moisture absorption of the glass particles that occurs after drying the composition for forming an n-type diffusion layer. As a result, changes in the diffusion amount of the donor element into a semiconductor substrate are suppressed, and vaporization of the donor element during thermal diffusion is suppressed, whereby an n-type diffusion layer can be formed in a stable manner more easily. Further, generation of an etching residue that may be caused by a component that has eluted by moisture absorption can be suppressed.

### (Glass particles including donor element)

The composition for forming an n-type diffusion layer according to the invention includes glass particles that include a donor element. The donor element is an element that is capable of forming an n-type diffusion layer in a semiconductor substrate upon doping. An element in the Group 15 may be used as the donor element, and examples thereof include P (phosphorus), Sb (antimony) and As (arsenic). From viewpoints of safety, easiness of vitrification (introduction into glass particles) and the like, P or Sb is suitable.

Examples of the donor element-containing substance, which is used for introducing a donor element into glass particles, include P₂O₃, P₂O₅, Sb₂O₃, Bi₂O₃ and As₂O₃, and at least one selected from P₂O₃, P₂O₅ and Sb₂O₃ is preferable.

Properties of the glass particles, such as melting temperature, softening point, glass transition temperature and chemical durability can be regulated by modifying the ratio of components, as necessary.

Examples of the glass component substance, which constitutes the glass particles, include SiO₂, K₂O, Na₂O, Li₂O, BaO, SrO, CaO, MgO, BeO, ZnO, PbO, CdO, V₂O₅, SnO, ZrO₂, La₂O₃, Nb₂O₅, Ta₂O₅, Y₂O₃, TiO₂, ZrO₂, GeO₂, TeO₂ and Lu₂O₃. Among them, at least one selected from SiO₂, K₂O, Na₂O, Li₂O, BaO, SrO, CaO, MgO, BeO, ZnO, PbO, CdO, V₂O₅, SnO, ZrO₂ and Mo₃ is preferable.

Specific examples of the glass particles that include a donor element include glasses of P₂O₅ system, such as P₂O₅-SiO₂ system, P₂O₅-K₂O system, P₂O₅-Na₂O system, P₂O₅-Li₂O system, P₂O₅-BaO system, P₂O₅-SrO system, P₂O₅-CaO system, P₂O₅-MgO system, P₂O₅-BeO system, P₂O₅-ZnO system, P₂O₅-CdO system, P₂O₅-PbO system, P₂O₅-V₂O₅ system, P₂O₅-SnO system, P₂O₅-GeO₂ system, P₂O₅-Sb₂O₃ system, P₂O₅-TeO₂ system and P₂O₅-As₂O₃ system, and Sb₂O₃ system glass.

The above examples are composite glasses including two components, but a composite glass including three or more components, such as P₂O₅-SiO₂-MgO, P₂O₅-SiO₂-CaO and P₂O₅-SiO₂-CaO-MgO, may be used as necessary.

The content of the glass component substance in the glass particles may be decided in view of a fusion temperature, a softening point, a glass transition temperature, chemical durability and the like. Generally, the content is preferably from 0.1 % by mass to 95 % by mass, and more preferably from 0.5 % by mass to 90 % by mass.

The softening point of the glass particles is preferably from 200°C to 1,000 °C from the viewpoint of diffusibility or an ability of suppressing dripping during the diffusion treatment, and the like, and more preferably from 300 °C to 900 °C.

The particle size of the glass particles is preferably 100 µm or less. In a case in which glass particles with a particle size of 100 µm or less is used, it tends to be easy to form a smooth composition layer by applying the composition for forming an n-type diffusion layer onto a surface of a semiconductor substrate. The particle size of the glass particles is more preferably 50 µm or less, and the particle size of the glass particle is further preferably 5 µm or less.

The glass particles including a donor element is produced by the following procedures. Firstly, a source material is weighed and placed in a crucible. Examples of the material of the crucible include platinum, an alloy of platinum and rhodium, gold, iridium, alumina, quartz and carbon, and can be chosen in view of a fusion temperature, an atmosphere, reactivity with a molten substance, and the like. Next, the source material is heated in an electrical oven at a temperature at which the glass composition becomes molten. In that case, the melt is preferably stirred so as to be homogeneous. Then, the melt is vitrified by casting onto a zirconia substrate, a carbon substrate or the like. Finally, the glass is crushed into the form of particles. For the crushing, a known apparatus such as a jet mill, a bead mill or a ball mill may be used.

The content of the glass particles including a donor element in the composition for forming an n-type diffusion layer may be determined in view of applicability to a semiconductor substrate, diffusibility of a donor element, and the like. Generally, the content of the glass particles in the composition for forming an n-type diffusion layer is preferably from 0.1 % by mass to 95 % by mass, more preferably from 1 % by mass to 90 % by mass, further preferably from 1 % by mass to 50 % by mass, and especially preferably from 5 % by mass to 40 % by mass.

### (Dispersing medium)

The composition for forming an n-type diffusion layer according to the invention includes a dispersing medium. The dispersing medium refers to a medium in which the glass particles are dispersed in the composition. Specifically, a binder, a solvent or a combination thereof may be used as the dispersing medium.

The binder may be an organic binder or an inorganic binder. Specific examples of the organic binder include a (dimethylamino)ethyl (meth)acrylate polymer, poly(vinyl alcohol), polyacrylamide, poly(vinyl amide), polyvinylpyrrolidone, poly((meth)acrylic acid), poly(ethylene oxide), polysulfone, an acrylamidoalkyl sulfonic acid, a cellulose derivative such as cellulose ether, carboxymethyl cellulose, hydroxyethyl cellulose and ethyl cellulose, gelatin, starch and a starch derivative, sodium alginate, xanthan, guar gum, a guar gum derivative, scleroglucan, tragacanth, dextrin, a dextrin derivative, an acrylic resin, an acrylic ester resin, a butadiene resin, a styrenic resin, and a copolymer thereof. Specific examples of the inorganic binder include silicon dioxide. The binders may be used singly or in combination of two or more kinds thereof.

There is no particular restriction on the weight-average molecular weight of the binder, and it should preferably be adjusted appropriately according to a desired viscosity of the composition.

Examples of the solvent include a ketone solvent, an ether solvent, an ester solvent, an ether acetate solvent, an aprotic polar solvent, an alcohol solvent, a glycol monoether solvent, a terpene solvent, and water. The solvents may be used singly or in combination of two or more kinds thereof.

Examples of the ketone solvent include acetone, methyl ethyl ketone, methyl n-propyl ketone, methyl isopropyl ketone, methyl n-butyl ketone, methyl isobutyl ketone, methyl n-pentyl ketone, methyl n-hexyl ketone, diethyl ketone, dipropyl ketone, diisobutyl ketone, trimethyl nonanone, cyclohexanone, cyclopentanone, methylcyclohexanone, 2,4-pentanedione, acetonylacetone, γ-butyrolactone, and γ-valerolactone.

Examples of the ether solvent include diethyl ether, methyl ethyl ether, methyl n-propyl ether, diisopropyl ether, tetrahydrofuran, methyltetrahydrofuran, dioxane, dimethyldioxane, ethylene glycol dimethyl ether, ethylene glycol diethyl ether, ethylene glycol di-n-propyl ether, ethylene glycol dibutyl ether, diethylene glycol dimethyl ether, diethylene glycol diethyl ether, diethylene glycol methyl ethyl ether, diethylene glycol methyl n-propyl ether, diethylene glycol methyl n-butyl ether, diethylene glycol di-n-propyl ether, diethylene glycol di-n-butyl ether, diethylene glycol methyl n-hexyl ether, triethylene glycol dimethyl ether, triethylene glycol diethyl ether, triethylene glycol methyl ethyl ether, triethylene glycol methyl n-butyl ether, triethylene glycol di-n-butyl ether, triethylene glycol methyl n-hexyl ether, tetraethylene glycol dimethyl ether, tetraethylene glycol diethyl ether, tetraethylene glycol methyl ethyl ether, tetraethylene glycol methyl n-butyl ether, tetraethylene glycol di-n-butyl ether, tetraethylene glycol methyl n-hexyl ether, tetraethylene glycol di-n-butyl ether, propylene glycol dimethyl ether, propylene glycol diethyl ether, propylene glycol di-n-propyl ether, propylene glycol dibutyl ether, dipropylene glycol dimethyl ether, dipropylene glycol diethyl ether, dipropylene glycol methyl ethyl ether, dipropylene glycol methyl mono-n-butyl ether, dipropylene glycol di-n-propyl ether, dipropylene glycol di-n-butyl ether, dipropylene glycol methyl n-hexyl ether, tripropylene glycol dimethyl ether, tripropylene glycol diethyl ether, tripropylene glycol methyl ethyl ether, tripropylene glycol methyl n-butyl ether, tripropylene glycol di-n-butyl ether, tripropylene glycol methyl n-hexyl ether, tetrapropylene glycol dimethyl ether, tetrapropylene glycol diethyl ether, tetrapropylene glycol methyl ethyl ether, tetrapropylene glycol methyl n-butyl ether, tetrapropylene glycol di-n-butyl ether, tetrapropylene glycol methyl n-hexyl ether, and tetrapropylene glycol di-n-butyl ether.

Examples of the ester solvent include methyl acetate, ethyl acetate, n-propyl acetate, isopropyl acetate, n-butyl acetate, isobutyl acetate, sec-butyl acetate, n-pentyl acetate, sec-pentyl acetate, 3-methoxybutyl acetate, methylpentyl acetate, 2-ethylbutyl acetate, 2-ethylhexyl acetate, 2-(2-butoxyethoxy)ethyl acetate, benzyl acetate, cyclohexyl acetate, methylcyclohexyl acetate, nonyl acetate, methyl acetoacetate, ethyl acetoacetate, diethylene glycol methyl ether acetate, diethylene glycol monoethyl ether acetate, diethylene glycol mono-n-butyl ether acetate, dipropylene glycol monomethyl ether acetate, dipropylene glycol monoethyl ether acetate, glycol diacetate, methoxy triethylene glycol acetate, ethyl propionate, n-butyl propionate, isoamyl propionate, diethyl oxalate, di-n-butyl oxalate, methyl lactate, ethyl lactate, n-butyl lactate, and n-amyl lactate.

Examples of the ether acetate solvent include ethylene glycol methyl ether propionate, ethylene glycol ethyl ether propionate, ethylene glycol methyl ether acetate, ethylene glycol ethyl ether acetate, diethylene glycol methyl ether acetate, diethylene glycol ethyl ether acetate, diethylene glycol n-butyl ether acetate, propylene glycol methyl ether acetate, propylene glycol ethyl ether acetate, propylene glycol propyl ether acetate, dipropylene glycol methyl ether acetate, and dipropylene glycol ethyl ether acetate.

Examples of the aprotic polar solvent include acetonitrile, N-methylpyrrolidinone, N-ethylpyrrolidinone, N-propylpyrrolidinone, N-butylpyrrolidinone, N-hexylpyrrolidinone, N-cyclohexylpyrrolidinone, N,N-dimethylformamide, N,N-dimethylacetamide, and N,N-dimethyl sulfoxide.

Examples of the alcohol solvent include methanol, ethanol, n-propanol, isopropanol, n-butanol, isobutanol, sec-butanol, t-butanol, n-pentanol, isopentanol, 2-methylbutanol, sec-pentanol, t-pentanol, 3-methoxybutanol, n-hexanol, 2-methylpentanol, sec-hexanol, 2-ethylbutanol, sec-heptanol, n-octanol, 2-ethylhexanol, sec-octanol, n-nonyl alcohol, n-decanol, sec-undecyl alcohol, trimethylnonyl alcohol, sec-tetradecyl alcohol, sec-heptadecyl alcohol, phenol, cyclohexanol, methylcyclohexanol, benzyl alcohol, ethylene glycol, 1,2-propylene glycol, 1,3-butylene glycol, diethylene glycol, dipropylene glycol, triethylene glycol, and tripropylene glycol.

Examples of the glycol monoether solvent include ethylene glycol methyl ether, ethylene glycol ethyl ether, ethylene glycol monophenyl ether, diethylene glycol monomethyl ether, diethylene glycol monoethyl ether, diethylene glycol mono-n-butyl ether, diethylene glycol mono-n-hexyl ether, ethoxy triglycol, tetraethylene glycol mono-n-butyl ether, propylene glycol monomethyl ether, dipropylene glycol monomethyl ether, dipropylene glycol monoethyl ether, and tripropylene glycol monomethyl ether.

Examples of the terpene solvent include terpinene, terpineol, myrcene, allo-ocimene, limonene, dipentene, pinene, carvone, ocimene, and phellandrene.

The content of the dispersing medium in the composition for forming an n-type diffusion layer may be determined according to applicability to a semiconductor substrate and the concentration of the donor element. Generally the content of the dispersing medium in the composition for forming an n-type diffusion layer is preferably from 4 % by mass to 95 % by mass, more preferably from 9 % by mass to 93 % by mass, further preferably from 49 % by mass to 90 % by mass, and especially preferably from 59 % by mass to 90 % by mass.

The viscosity of the composition for forming an n-type diffusion layer is preferably from 10 mPa·s to 1,000,000 mPa·s at 25 °C, from the viewpoint of easy application to a semiconductor substrate, and more preferably from 50 mPa·s to 500,000 mPa·s. The viscosity can be measured with an E-type viscometer.

### (Organometallic compound)

The composition for forming an n-type diffusion layer according to the invention includes at least one kind of organometallic compound.

In the invention, a metal salt of an organic acid, a metal alkoxide, a compound including a bond between a metal atom and an oxygen atom, such as a silicone resin, and a compound including a bond between a metal atom and a nitrogen atom, such as an alkylsilazane compound, are also encompassed in the organometallic compound, in addition to a compound including a bond between a metal atom and a carbon atom.

Examples of the organometallic compound include a metal alkoxide, a silicone resin, and an alkylsilazane compound. The organometallic compound may be used singly or in combination of two or more kinds thereof. The organometallic compound is included as an oxide in a glass layer that is formed on a semiconductor substrate from molten glass particles by performing a thermal treatment to the composition for forming an n-type diffusion layer. Therefore, an organometallic compound including a silicon atom is preferable from the viewpoint of readily dissolving in hydrofluoric acid to be removed. Alternatively, from the viewpoint of improving the humidity resistance of the glass particles, a metal alkoxide is more preferable, and a silane coupling agent is further preferable.

### «Metal alkoxide»

There is no particular restriction on the metal alkoxide, insofar as it is a compound obtained by reaction of a metal atom with an alcohol. Specific examples of the metal alkoxide include a compound expressed by the following Formula (1) and a silane coupling agent.

M(OR¹)ₐ (1)

In Formula (1), M is a metal element having a valence of 1 to 7. Specific examples of M include a metal atom selected from the group consisting of Li, Na, K, Mg, Ca, Sr, Ba, La, Ti, B, Zr, Hf, V, Nb, Ta, Cr, Mo, W, Mn, Fe, Co, Ni, Cu, Zn, Pb, Bi and Si. From the viewpoint of power generation efficiency of a photovoltaic cell element, a metal atom selected from the group consisting of Li, Na, K, Mg, Ca, Sr, Ba, La, Ti, B, Zr, Hf, V, Nb, Ta, Mo, Co, Zn, Pb, Bi and Si is preferable, and Si, Mg, Ca or Ti is more preferable. R¹ is a residue of an alcohol from which an OH group is removed.

Examples of a favorable alcohol that forms the metal alkoxide include an alcohol expressed by the following Formula (2).

R¹OH (2)

In Formula (2), R¹ represents a saturated or unsaturated hydrocarbon group having from 1 to 6 carbon atoms, or a hydrocarbon group having from 1 to 6 carbon atoms that is substituted by an alkoxy group having from 1 to 6 carbon atoms.

In a case in which R¹ in Formula (2) is a saturated or unsaturated hydrocarbon group having from 1 to 6 carbon atoms, examples of the alcohol expressed by Formula (2) include methanol, ethanol, 1-propanol, 2-propanol, butanol, amyl alcohol, and cyclohexanol.

In a case in which R¹ in Formula (2) is a hydrocarbon group having from 1 to 6 carbon atoms that is substituted by an alkoxy group having from 1 to 6 carbon atoms, examples of the alcohol expressed by Formula (2) include methoxymethanol, methoxyethanol, ethoxymethanol, ethoxyethanol, methoxypropanol, ethoxypropanol, and propoxypropanol.

Among the metal alkoxides, a silicon alkoxide is preferable from the viewpoint of suppressing a decline in diffusibility of phosphorus or contamination of a semiconductor substrate. Among the silicon alkoxides, tetraethoxysilane (used in Example 6), and tetramethoxysilane are more preferable, and tetraethoxysilane is further preferable in view of safety. A metal alkoxide may be used, if necessary, in combination with water, a catalyst or the like.

There is no particular restriction on the silane coupling agent, insofar as it is a compound having a silicon atom, an alkoxy group, and an organic functional group that is different from an alkoxy group, in a single molecule. By using a silane coupling agent as an organometallic compound, it is considered that humidity resistance of the glass particles is further improved. Specifically, it is presumed that a silanol group generated by hydrolysis of the alkoxy group interacts with a surface of a glass particle and is bonded thereto by dehydration reaction. Meanwhile, a hydrophobic functional group, or a functional group capable of bonding with a binder if it exists as a dispersing medium, is oriented toward a surface (outer side of the glass particle). As a result, it is considered that the humidity resistance of the glass particle is improved.

Specific examples of the silane coupling agent include a compound expressed by the following Formula (3) or a compound expressed by the following Formula (4).

XₙR²⁰₍₃₋ₙ₎SiR¹⁰-Y (3)

XₙR²⁰₍₃₋ₙ₎Si-Y (4)

In Formula (3) and Formula (4), X represents a methoxy group or an ethoxy group; Y represents a vinyl group, a mercapto group, an epoxy group, an amino group, a styryl group, an isocyanurate group, an isocyanate group, a (meth)acryloyl group, a glycidoxy group, a ureido group, a sulfide group, a carboxy group, a (meth)acryloxy group, an alkyl group, a phenyl group, a trifluoroalkyl group, an alkylene glycol group, an amino alcohol group, a quaternary ammonium, and the like. Among them, Y is preferably, a vinyl group, an amino group, an epoxy group, a (meth)acryloxy group, an alkyl group or a trifluoroalkyl group, and more preferably an acryloxy group or a trifluoromethyl group.

In Formula (3), R¹⁰ represents an alkylene group having from 1 to 10 carbon atoms, or a divalent linking group with a main chain that has a number of atoms of 2 to 5 and includes a nitrogen atom. The alkylene group is preferably an ethylene group or a propylene group. The atomic group including a nitrogen atom of the linking group is preferably an amino group or the like.

In Formula (3) and Formula (4), R²⁰ represents an alkyl group having from 1 to 5 carbon atoms, preferably a methyl group or an ethyl group, more preferably a methyl group. n represents an integer from 1 to 3.

Specific examples of the silane coupling agent include silane coupling agents corresponding to the following (a) to (g).
(a) A silane coupling agent having a (meth)acryloxy group, such as (3-acryloxypropyl)trimethoxysilane (used in Examples 1,3,4 and 5), (3-methacryloxypropyl)methyldimethoxysilane, (3-methacryloxypropyl)trimethoxysilane (used in Example 2), (3-methacryloxypropyl)dimethyldiethoxysilane, and (3-methacryloxypropyl)triethoxysilane
(b) A silane coupling agent having an epoxy group or a glycidoxy group, such as (3-glycidoxypropyl)trimethoxysilane, (3-glycidoxypropyl)methyldimethoxysilane, and 2-(3,4-epoxycyclohexyl)ethyltrimethoxysilane
(c) A silane coupling agent having an amino group, such as N-(2-aminoethyl)-3-aminopropylmethyldimethoxysilane, N-(aminoethyl)-3-aminopropyltrimethoxysilane, and (3-aminopropyl)triethoxysilane.
(d) A silane coupling agent having a mercapto group, such as (3-mercaptopropyl)trimethoxysilane
(e) A silane coupling agent having an alkyl group, such as methyltrimethoxysilane (used in Example 7), dimethyldimethoxysilane, methyltriethoxysilane, dimethyldiethoxysilane, n-propyltrimethoxysilane, n-propyltriethoxysilane, hexyltrimethoxysilane, hexyltriethoxysilane, octyltriethoxysilane, decyltrimethoxysilane, and 1,6-bis(trimethoxysilyl)hexane
(f) A silane coupling agent having a phenyl group, such as phenyltrimethoxysilane and phenyltriethoxysilane
(g) A silane coupling agent having a trifluoroalkyl group, such as trifluoropropyltrimethoxysilane

Among the silane coupling agents, from the viewpoint of suppressing contamination of the oven in a diffusion process, a silane coupling agent having a (meth)acryloxy group, a silane coupling agent having an alkyl group, a silane coupling agent having an amino group, or a silane coupling agent having a glycidoxy group is preferable. From the viewpoint of further protecting the glass particles by bonding with a dispersing medium (a binder, a solvent or a combination thereof) in the composition for forming an n-type diffusion layer through a coupling reaction, a silane coupling agent having a (meth)acryloxy group, a silane coupling agent having an amino group, or a silane coupling agent having a glycidoxy group is more preferable.

As a silane coupling agent having a (meth)acryloxy group, (3-acryloxypropyl)trimethoxysilane and (3-methacryloxypropyl)trimethoxysilane are further preferable. As a silane coupling agent having an alkyl group, methyltrimethoxysilane and propyltrimethoxysilane are further preferable. As a silane coupling agent having an amino group, N-(2-aminoethyl)-3-aminopropyl methyldimethoxysilane and N-(aminoethyl)-3-aminopropyl trimethoxysilane are further preferable. As a silane coupling agent having a glycidoxy group, (3-glycidoxypropyl)trimethoxysilane is further preferable.

### «Silicone resin»

There is no particular restriction on the type, structure or the like of the silicone resin, insofar as it is a compound having a Si-O-Si bond (siloxane bond) and an organic group bonding with at least part of the silicon atoms. For example, the silicon resin may be either a thermally curing silicone resin or a thermally degradable silicone resin. There is no particular restriction on the organic group bonding with a silicon atom that constitutes the silicone resin, and examples thereof include a phenyl group, an alkyl group, a polyether, an epoxy group, an amino group, a carboxy group, an aralkyl group, and a fluoroalkyl group. From the viewpoint of allowing the glass particles to be more hydrophobic by closely attaching thereto, the organic group is preferably an alkyl group (more preferably a methyl group or an ethyl group) or a fluoroalkyl group. The silicone resin is preferably a liquid (i.e., having a kinematic viscosity of 100,000 mm²/s or less at 25 °C), such as a silicone oil. Specific examples of the silicone resin include polydimethylsiloxane (used in Example 8), poly(methyl phenyl siloxane) in which a part of methyl groups of polydimethylsiloxane are substituted by a phenyl group, and a silicone resin in which a part of methyl groups in polydimethylsiloxane are substituted by a hydrogen atom, an amino group, an epoxy group, a carboxy group or the like. Among them, polydimethylsiloxane is preferable from the viewpoint of suppressing contamination of the oven in a diffusion process.

There is no particular restriction on the molecular weight of the silicone resin. For example, the weight-average molecular weight is preferably from 1,000 to 100,000, and more preferably from 1,000 to 20,000.

There is no particular restriction on the viscosity of the silicone resin at 25 °C. For example, the kinematic viscosity at 25 °C is preferably from 10 to 100,000 mm²/s, and more preferably from 10 to 1,000 mm²/s. A kinematic viscosity can be measured by a capillary viscometer.

### «Alkylsilazane compound»

There is no particular restriction on the alkylsilazane compound, insofar as it is a compound that has a structure in which a silicon atom and a nitrogen atom are bonded with each other, and has an alkyl group or a fluoroalkyl group, in its molecule. Specific examples of the alkyl group include a methyl group, an ethyl group, a propyl group, an amino group, a fluoromethyl group, a fluoroethyl group and a fluoropropyl group. Specific examples of the alkylsilazane compound include 1,1,1,3,3,3-hexamethyldisilazane, heptamethyldisilazane, and 1,3-bis(3,3,3-trifluoropropyl)-1,1,3,3-tetramethylpropanedisilazane.

The content of the organometallic compound in the composition for forming an n-type diffusion layer is preferably from 0.01 % by mass to 20 % by mass in the total mass of the composition for forming an n-type diffusion layer, more preferably from 0.3 % by mass to 10 % by mass, and further preferably from 0.5 % by mass to 5 % by mass. When the content of the organometallic compound is 0.01 % by mass or more, the organometallic compound can closely attach to a surface of a glass particle, and a function of protecting the glass particle from contacting with water tends to improve. When the content of the organometallic compound is 20 % by mass or less, deterioration in diffusibility may be suppressed.

There is no particular restriction on the method of adding the organometallic compound to the composition for forming an n-type diffusion layer. Examples thereof include a method of mixing an organometallic compound with glass particles, a dispersing medium, and other components if necessary, and a method of mixing an organometallic compound with glass particles and stirring, and then mixing the same with a dispersing medium. From the viewpoint of facilitating attachment to a surface of the glass particles, a method of mixing an organometallic compound with glass particles and stirring, and then mixing the same with a dispersing medium is preferred. The method may be either a dry method or a wet method, and a wet method is preferred from the viewpoint of suppressing moisture absorption. Specific examples of the wet method include a method of adding glass particles and an organometallic compound to a binder, a solvent or a mixture thereof to be used as a dispersing medium, and then stirring. Although there is no particular restriction on the means for stirring, a bead mill, a ball mill and the like are preferable from the viewpoint of performing pulverization of the glass particles in the same process.

### (Other components)

The composition for forming an n-type diffusion layer according to the invention may include other components, if necessary. Examples of the other components include a thixotropy imparting agent, such as an organic filler, an inorganic filler and an organic salt, a wettability improvement agent, a leveling agent, a surfactant, a plasticizer, a filler, a defoaming agent, a stabilizer, an antioxidant, and a fragrance. There is no particular restriction on the content of these components. For example, it is possible to use each of the components by an amount of approximately 0.01 parts by mass to 20 parts by mass with respect to 100 parts by mass of the total composition for forming an n-type diffusion layer. The components may be used singly or in combination of two or more kinds thereof.

### <Method of forming n-type diffusion layer and method of producing semiconductor substrate with n-type diffusion layer>

The method of forming an n-type diffusion layer according to the invention includes a process of applying the composition for forming an n-type diffusion layer onto a semiconductor substrate, and thermally treating the semiconductor substrate applied with the composition for forming an n-type diffusion layer.

The method of producing a semiconductor substrate with an n-type diffusion layer according to the invention includes a process of applying the composition for forming an n-type diffusion layer onto a semiconductor substrate, and forming an n-type diffusion layer by thermally treating the semiconductor substrate applied with the composition for forming an n-type diffusion layer.

The semiconductor substrate is not particularly limited, and may be selected from commonly used semiconductor substrates. The method of applying the composition for forming an n-type diffusion layer onto a semiconductor substrate is not particularly limited, and examples include a printing method, a spin coat method, a painting method, a spray method, a doctor blade method, a roll coat method and an inkjet method. The temperature of the thermal treatment is not particularly limited, as long as a donor element can diffuse into a semiconductor substrate to form an n-type diffusion layer. For example, the temperature may be selected from 600 °C to 1200 °C. The method for the thermal treatment is not particularly limited, and may be performed with a known continuous furnace or a batch furnace.

### <Method of producing photovoltaic cell element>

The method of producing a photovoltaic cell element according to the invention includes a process of applying the composition for forming an n-type diffusion layer onto a semiconductor substrate, a process of forming an n-type diffusion layer by thermally treating the semiconductor substrate applied with the composition for forming an n-type diffusion layer, and a process of forming an electrode on the n-type diffusion layer.

The material of an electrode formed on the n-type diffusion layer or the method of forming the same is not particularly limited. For example, the electrode may be formed by applying a paste for an electrode including a metal such as aluminum, silver or copper to a desired region, and thermally treating the same.

Examples of the structure of the photovoltaic cell element include a structure in which an electrode is formed both on a light-receiving surface and a back surface, and a method in which an electrode is formed only on a back surface (back contact-type). The back contact-type photovoltaic cell element has an electrode only on the back surface in order to improve the conversion efficiency by increasing the area of the light-receiving surface. In that case, an n-type diffusion region and a p⁺-type diffusion region need to be formed on the back surface of a semiconductor substrate to provide a pn junction structure. The composition for forming an n-type diffusion layer is capable of forming an n-type diffusion region to a specific region of a semiconductor substrate in a selective manner. Therefore, the composition for forming an n-type diffusion layer may be suitably used in the production of a back contact-type photovoltaic cell element.

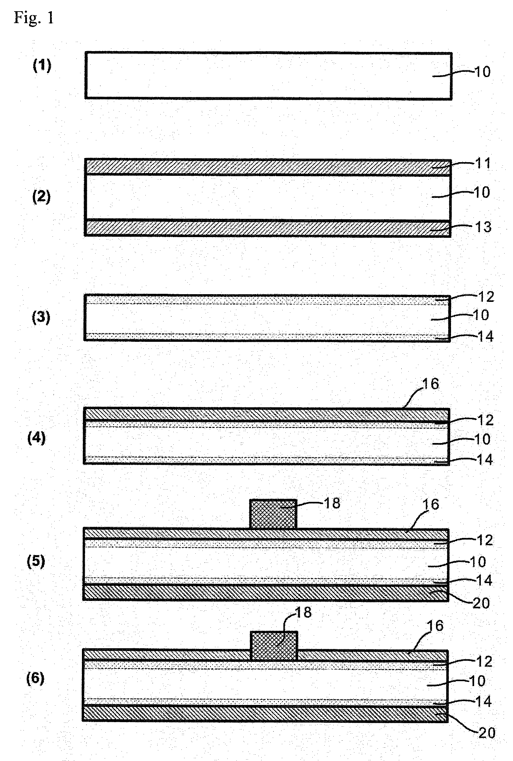

In the following, an example of the method of producing a semiconductor substrate with an n-type diffusion layer or the method of producing a photovoltaic cell element will be described with reference to Fig. 1. Fig. 1 is a schematic cross sectional view of an exemplary process of producing a photovoltaic cell element according to the invention. In the following drawings, the same number is assigned to the identical component.

In Fig. 1(1), an alkali solution is applied onto a silicon substrate (p-type semiconductor substrate 10) to remove a damage layer, and a texture structure is obtained by etching. Specifically, a damage layer at a surface of a silicon substrate, which is generated upon slicing an ingot, is removed with sodium hydroxide (20% by mass). Subsequently, a texture structure (not shown) is formed by performing etching with a mixture of sodium hydroxide (1% by mass) and isopropyl alcohol (10% by mass). By forming a texture structure at a light-receiving surface side, an optical confinement effect is promoted and efficiency of a photovoltaic cell element is enhanced.

In Fig. 1(2), composition for forming an n-type diffusion layer 11 is applied onto a surface that is to become the light-receiving surface of p-type semiconductor substrate. The method of application is not particularly limited, and examples include a printing method, a spin coat method, a painting method, a spray method, a doctor blade method, a roll coat method and an inkjet method. On the back surface of p-type semiconductor substrate 10, composition for forming p-type diffusion layer 12, which contains an element of the Group 13 such as aluminum or boron, is applied for forming p⁺-type diffusion layer (high-concentration electric field layer) 14.

Depending on the components of the composition for forming an n-type diffusion layer, a process for drying in which a solvent included in the composition as a dispersion medium is evaporated may need to be performed after the application of the composition. For example, the drying may be performed at a temperature of from 80 °C to 300 °C, for from 1 minute to 10 minutes with a hot plate or for from 10 minutes to 30 minutes with a drier or the like. The conditions for drying are not particularly limited to the above, and depend on the solvent in the composition for forming an n-type diffusion layer.

In Fig. 1(3), semiconductor substrate 10 that has been applied with composition for forming n-type diffusion layer 11 and composition for forming p-type diffusion layer 13 at from 600 °C to 1200 °C is thermally treated. Though the thermal treatment, a donor element diffuses into the semiconductor substrate and n-type diffusion layer 12 is formed on the light-receiving surface. The thermal treatment may be performed with a known means such as a continuous furnace or a batch furnace. Since a glass layer such as phosphate glass (not shown) is formed on n-type diffusion layer 12, etching is performed to remove the phosphate glass. The etching may be performed by a known method such as a method of immersing in an acid such as hydrofluoric acid or a method of immersing in an alkali such as sodium hydroxide. On the back surface of p-type semiconductor substrate 10, p⁺-type diffusion layer (high-concentration electric field layer) 14 is formed by the thermal treatment.

In the method of forming n-type diffusion layer 12 with composition for forming an n-type diffusion layer 11, as shown in Fig. 1(2) and Fig. 1(3), n-type diffusion layer 12 is formed only at a desired portion and unnecessary n-type diffusion layers are not formed at the back surface or side surfaces. Therefore, it is possible to omit side etching, which is an essential process in a case of forming an n-type diffusion layer by a gas phase method, and production process can be simplified.

In a conventional method, it is necessary to convert an n-type diffusion layer formed on the back surface to a p-type diffusion layer. For this purpose, generally, a paste of aluminum, which is a Group 13 element, is applied on an n-type diffusion layer formed on the back surface and thermally treated so that aluminum is diffused into the n-type diffusion layer to covert the same to a p-type diffusion layer. In order to achieve sufficient conversion to a p-type diffusion layer, and to form a p⁺-type diffusion layer, a certain amount of aluminum is necessary and a thick aluminum layer needs to be formed. In that case, however, since the coefficient of thermal expansion of aluminum is greatly different from that of silicon used for a semiconductor substrate, a large internal stress is generated in the semiconductor substrate during the thermal treatment and cooling.

The internal stress may damage the crystal grain boundary in crystals, and may cause an increase in power loss of a photovoltaic cell element. In addition, warpage of the semiconductor substrate that may be caused by the internal stress makes the photovoltaic cell element to be prone to breakage during transportation in a module process or connecting with a copper line (referred to as tab line). In recent years, as the techniques in slicing and processing improve, and the thickness of a semiconductor substrate tends to decrease, it tends to become easier to break.

According to the method of the invention, since unnecessary n-type diffusion layers are not formed on the back surface of the semiconductor substrate, there is no need to convert the n-type diffusion layer to a p-type diffusion layer, and there is no need to form a thick aluminum layer. As a result, occurrence of internal stress in the semiconductor substrate and warpage thereof can be suppressed. Consequently, it becomes possible to suppress an increase in power loss of a photovoltaic cell element and breakage of the same.

Further, in the method according to the invention, the method of forming a p⁺-type diffusion layer (high-concentration electric field layer) 14 is not limited to a method of converting the n-type diffusion layer to a p-type diffusion layer with aluminum, and may be selected form any other methods. In addition, as mentioned later, use of materials other than aluminum, such as Ag (silver) or Cu (copper) for light-receiving surface electrode 20 becomes possible. It also becomes possible to form back surface electrode 20 with a smaller thickness than the conventional electrodes.

In Fig. 1(4), anti-reflection film 16 is formed on n-type diffusion layer 12. Anti-reflection film 16 can be formed by a known method. For example, in a case that anti-reflection film 16 is a silicon nitride film, it can be formed by a plasma CVD method using a mixed gas of SiH₄ and NH₃ as a raw material. In that case, hydrogen atoms are diffused into crystals and an orbit that does not contribute to bonding with a silicon atom (i.e., dangling bond) is bonded with a hydrogen atom, thereby inactivating the defects (hydrogen passivation). More specifically, the anti-reflection film may be formed at a flow rate of mixed gas (SiH₄/NH₃) of from 0.05 to 1.0, a pressure in a reaction chamber of from 13.3 Pa to 266.6 Pa (0.1 Torr to 2 Torr), a temperature during film formation of from 300 °C to 550 °C, and a frequency for plasma discharge of 100 kHz or more.

In Fig. 1(5), light-receiving surface electrode 18 (before thermal treatment) is formed by applying a metal past for forming a light-receiving surface electrode on anti-reflection 16, and drying the same. The composition of the metal paste is not particularly limited. For example, it may include metal particles and glass particles as essential components and a resin binder and other additives as necessary.

Subsequently, back surface electrode 20 is formed on p⁺-type diffusion layer 14 at the back surface. As mentioned above, the material of back surface electrode 20 or the method of forming the same is not particularly limited. For example, back surface electrode 20 may be formed by using a paste including a metal other than aluminum such as silver or copper. It is also possible to provide a silver paste for forming a silver electrode at a portion of the back surface, for the purpose of connecting the cells in the module process.

In Fig. 1(6), light-receiving surface electrode 18 (before thermal treatment) is thermally treated so as to electrically connect with p-type semiconductor substrate 10, thereby obtaining a photovoltaic cell element. In the thermal treatment performed at 600 °C to 900 °C for from several seconds to several minutes, at the light-receiving surface side, anti-reflection film 16, which is an insulating film, becomes molten by glass particles included in light-receiving surface electrode 18 (before thermal treatment). Further, a surface of p-type semiconductor substrate 10 partially becomes molten, and metal particles (for example, silver particles) in light-receiving surface electrode 18 (before thermal treatment) form a contact portion with p-type semiconductor substrate 10 and solidify. In this way, light-receiving surface electrode 18 that is in electrical connection with p-type semiconductor substrate 10 is formed. This process is referred to as fire through.

In the method of producing a semiconductor substrate with an n-type diffusion layer or the method of producing a photovoltaic cell element, the processes of forming an n-type diffusion layer at the light-receiving surface of a p-type semiconductor substrate, a p⁺-diffusion layer on the back surface, an anti-reflection film, a light-receiving surface electrode and a back surface electrode are not limited to the order shown in Fig. 1, and may be performed in any order.

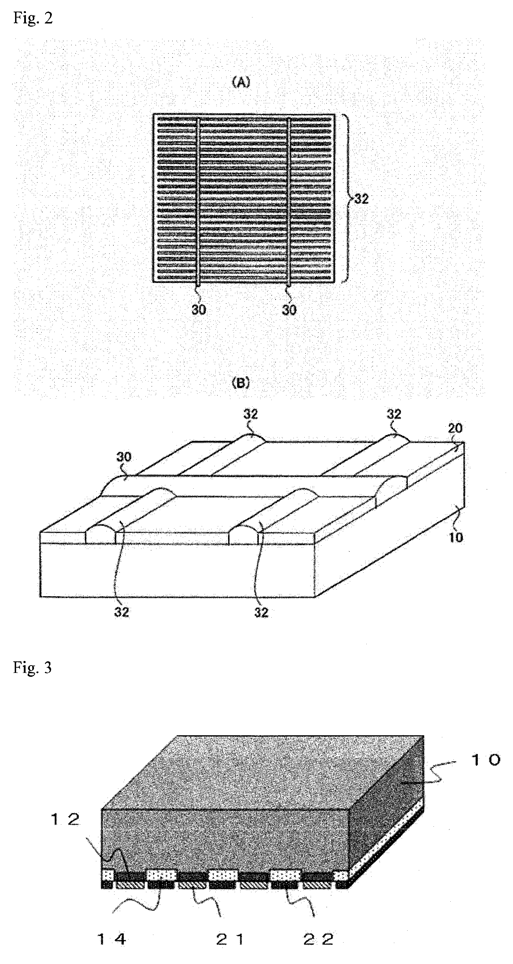

Fig. 2 is a schematic view of an example of a structure of an electrode of the photovoltaic cell element according to the invention. Light-receiving surface electrode 18 is formed from bus bar electrodes 30 and finger electrodes 32 that are positioned across bus bar electrodes 30. Fig. 2(A) is a plan view from the light-receiving surface of a photovoltaic cell element having light-receiving surface electrode 18 formed of bus bar electrodes 30 and finger electrodes 32 that are positioned to cross bus bar electrodes 30. Fig. 2(B) is a perspective view of a portion of Fig. 2(A).

Light-receiving electrode 18 as shown in Fig. 2 can be formed by, for example, application of a metal paste by screen printing, plating with an electrode material, or depositing an electrode material by electron beam heating in a highly vacuum environment. Light-receiving electrode 18 formed from bus bar electrodes 30 and finger electrodes 32 is commonly used as an electrode at the light-receiving surface side, and may be formed by a known means.

The above description concerns a photovoltaic cell element that has an n-type diffusion layer at the light-receiving surface and a p⁺-type diffusion layer at the back surface, and has a light-receiving surface electrode and a back surface electrode formed on the layers, respectively. However, the composition for forming an n-type diffusion layer is suitably used for producing a back contact-type photovoltaic cell element.

Fig. 3 shows an exemplary structure of a back contact-type photovoltaic cell element. The electrode of a back contact-type photovoltaic cell element as shown in Fig. 3 includes back surface electrode 21 that is provided in a patterned manner on n-type diffusion layer 12 that is formed in a patterned manner on the back surface of p-type semiconductor substrate 10; and back surface electrode 22 that is provided in a patterned manner on p⁺-type diffusion layer 14 that is formed in a patterned manner on the back surface of p-type semiconductor substrate 10. Such a structure in which an electrode is not formed on the light-receiving surface enables a broader light-receiving surface and improves the conversion efficiency of the photovoltaic cell element.

### EXAMPLES

In the following, the invention is described in further detail with reference to the examples. However, the invention is not limited to the examples. The chemicals used herein are all reagents, unless otherwise specified. The "%" refers to "% by mass", unless otherwise specified.

### <Example 1>

Particles of P₂O₅-SiO₂-MgO glass (P₂O₅: 52.8%, SiO₂: 37.2%, MgO: 10.0%) 10 g, 3-acryloxypropyltrimethoxysilane (KBM 5103, Shin-Etsu Chemical Co., Ltd.) 0.5 g, ethyl cellulose (ETHOCEL STD200, the Dow Chemical Company) 6.8 g and terpineol (TERPINEOL LW, Nippon Terpene Chemicals, Inc.) 82.7 g were mixed to form a paste. A composition for forming an n-type diffusion layer including 0.5% of 3-acryloxypropyltrimethoxysilane as an organometallic compound was thus prepared.

Subsequently, the composition for forming an n-type diffusion layer was applied onto a surface of a p-type silicon substrate by screen printing in the shape of a square (50 mm x 50 mm) (application amount: 40 mg), and dried on a hot plate at 220°C for 5 minutes. Within 30 minutes after the drying, a thermal treatment was performed in an electric furnace set at 950°C for 15 minutes, and an n-type diffusion layer was formed. Thereafter, the p-type silicon substrate was immersed in 5% hydrofluoric acid for 5 minutes to remove a glass layer formed on the surface. Then, the p-type silicon substrate was washed with running water and dried.

The sheet resistance at the surface of the p-type silicon substrate, at the side at which the n-type diffusion layer was formed, was 15 Ω/cm², which confirmed that an n-type diffusion layer was formed. The sheet resistance at the back surface of the p-type silicon substrate was over 1,000,000 Ω/cm² and not measurable, which confirmed that an n-type diffusion layer was not formed. Further, it was confirmed that there was no etching residue at a region at which the n-type diffusion layer was formed.

Subsequently, occurrence of out-diffusion was evaluated by secondary ion mass spectroscopy (SIMS). An SIM apparatus (IMS-6, Cameca Instruments Japan K.K.) was used for the evaluation. The evaluation was conducted by measuring the phosphorus concentration by performing SIM analysis at a portion applied with the composition for forming an n-type diffusion layer, and at a point 2 mm away from the outline of the portion applied with the composition for forming an n-type diffusion layer, respectively. The phosphorus concentration was 10²¹ atoms/cm³ at the portion applied with the composition for forming an n-type diffusion layer, and the phosphorus concentration was 10¹⁸ atoms/cm³ at the point 2 mm away from the outline of the portion applied with the composition for forming an n-type diffusion layer, which was 1/1,000 of the former phosphorus concentration. The result confirmed that out-diffusion was sufficiently suppressed.

Subsequently, the same composition for forming an n-type diffusion layer was applied onto a surface of a p-type silicon substrate and dried for 5 minutes on a hot plate at 220°C. Then, the silicon substrate was left under a high humidity condition of 25°C and 55% RH for 3 hours. Subsequently, a thermal treatment was performed in an electric furnace set at 950°C for 15 minutes. Thereafter, the silicon substrate was immersed in 5% hydrofluoric acid for 5 minutes to remove a glass layer formed on the surface. The sheet resistance at the surface of the silicon substrate, at the side at which the n-type diffusion layer was formed, was 15 Ω/cm², which showed that the amount of diffused phosphorus did not change between a case in which the composition for forming an n-type diffusion layer was left under a high humidity condition after drying, and a case in which the composition was not left under a high humidity condition. Further, it was confirmed that there was no etching residue.

### <Example 2>

A composition for forming an n-type diffusion layer including 0.5% of 3-methacryloxypropyltrimethoxysilane as an organometallic compound was prepared in the same manner as Example 1, except that 3-acryloxypropyltrimethoxysilane was replaced with the same amount of 3-methacryloxypropyltrimethoxysilane (LS-3380, Shin-Etsu Chemical Co., Ltd.)

Subsequently, the sheet resistance was measured by the same process as Example 1. As a result, the sheet resistance at the surface of the silicon substrate, at the side at which the n-type diffusion layer was formed, was 15 Ω/cm², which confirmed that an n-type diffusion layer was formed by diffusion of P (phosphorus). The sheet resistance at the back surface of the p-type silicon substrate was over 1,000,000 Ω/cm² and not measurable, which confirmed that an n-type diffusion layer was not formed. Further, it was confirmed that there was no etching residue at a region at which the n-type diffusion layer was formed.

Subsequently, occurrence of out-diffusion was evaluated by secondary ion mass spectroscopy (SIMS) in the same manner as Example 1. The phosphorus concentration was 10²¹ atoms/cm³ at the portion applied with the composition for forming an n-type diffusion layer, and the phosphorus concentration was 10¹⁸ atoms/cm³ at the point 2 mm away from the outline of the portion applied with the composition for forming an n-type diffusion layer, which was 1/1,000 of the former phosphorus concentration. The result confirmed that out-diffusion was sufficiently suppressed.

Subsequently, the composition for forming an n-type diffusion layer was dried and left under a high humidity condition, and subjected to a thermal treatment and hydrofluoric treatment, in the same manner to Example 1. Then, the sheet resistance was measured. The sheet resistance was 16 Ω/cm², which showed that the change in the amount of diffusion of phosphorus was little between a case in which the composition for forming an n-type diffusion layer was left under a high humidity condition after drying and a case in which the composition was not left under a high humidity condition. Further, it was confirmed that there was no etching residue.

### <Example 3>

A composition for forming an n-type diffusion layer including 0.5% of N-2-(aminoethyl)-3-aminopropylmethyldimethoxysilane as an organometallic compound was prepared in the same manner as Example 1, except that 3-acryloxypropyltrimethoxysilane was replaced with the same amount of N-2-(aminoethyl)-3-aminopropylmethyldimethoxysilane (KBM-602, Shin-Etsu Chemical Co., Ltd.)

Subsequently, the sheet resistance was measured by the same process as Example 1. As a result, the sheet resistance at the surface of the silicon substrate, at the side at which the n-type diffusion layer was formed, was 13 Ω/cm², which confirmed that an n-type diffusion layer was formed by diffusion of P (phosphorus). The sheet resistance at the back surface of the p-type silicon substrate was over 1,000,000 Ω/cm² and not measurable, which confirmed that an n-type diffusion layer was not formed. Further, it was confirmed that there was no etching residue at a region at which the n-type diffusion layer was formed.

Subsequently, occurrence of out-diffusion was evaluated by secondary ion mass spectroscopy (SIMS) in the same manner as Example 1. The phosphorus concentration was 10²¹ atoms/cm³ at the portion applied with the composition for forming an n-type diffusion layer, and the phosphorus concentration was 10¹⁷ atoms/cm³ at the point 2 mm away from the outline of the portion applied with the composition for forming an n-type diffusion layer, which was 1/10,000 of the former phosphorus concentration. The result confirmed that out-diffusion was sufficiently suppressed.

Subsequently, the composition for forming an n-type diffusion layer was dried and left under a high humidity condition, and subjected to a thermal treatment and hydrofluoric treatment, in the same manner to Example 1. Then, the sheet resistance was measured. The sheet resistance was 13 Ω/cm², which showed that the change in the amount of diffusion of phosphorus was little between a case in which the composition for forming an n-type diffusion layer was left under a high humidity condition after drying and a case in which the composition was not left under a high humidity condition. Further, it was confirmed that there was no etching residue.

### <Example 4>

A composition for forming an n-type diffusion layer including 0.3% of 3-acryloxypropyltrimethoxysilane as an organometallic compound was prepared in the same manner as Example 1, except that the amount of 3-acryloxypropyltrimethoxysilane was changed from 0.5 g to 0.3 g.

Subsequently, the sheet resistance was measured by the same process as Example 1. As a result, the sheet resistance at the surface of the silicon substrate, at the side at which the n-type diffusion layer was formed, was 15 Ω/cm², which confirmed that an n-type diffusion layer was formed by diffusion of P (phosphorus). The sheet resistance at the back surface of the p-type silicon substrate was over 1,000,000 Ω/cm² and not measurable, which confirmed that an n-type diffusion layer was not formed. Further, it was confirmed that there was no etching residue at a region at which the n-type diffusion layer was formed.

Subsequently, occurrence of out-diffusion was evaluated by secondary ion mass spectroscopy (SIMS) in the same manner as Example 1. The phosphorus concentration was 10²¹ atoms/cm³ at the portion applied with the composition for forming an n-type diffusion layer, and the phosphorus concentration was 10¹⁸ atoms/cm³ at the point 2 mm away from the outline of the portion applied with the composition for forming an n-type diffusion layer, which was 1/1,000 of the former phosphorus concentration. The result confirmed that out-diffusion was sufficiently suppressed.

Subsequently, the composition for forming an n-type diffusion layer was dried and left under a high humidity condition, and subjected to a thermal treatment and hydrofluoric treatment, in the same manner to Example 1. Then, the sheet resistance was measured. The sheet resistance was 16 Ω/cm², which showed that the change in the amount of diffusion of phosphorus was little between a case in which the composition for forming an n-type diffusion layer was left under a high humidity condition after drying and a case in which the composition was not left under a high humidity condition. Further, it was confirmed that there was no etching residue.

### <Example 5>

A composition for forming an n-type diffusion layer including 15.0% of 3-acryloxypropyltrimethoxysilane as an organometallic compound was prepared in the same manner as Example 1, except that the amount of 3-acryloxypropyltrimethoxysilane was changed from 0.5 g to 15.0 g.

Subsequently, the sheet resistance was measured by the same process as Example 1. As a result, the sheet resistance at the surface of the silicon substrate, at the side at which the n-type diffusion layer was formed, was 18 Ω/cm², which confirmed that an n-type diffusion layer was formed by diffusion of P (phosphorus). The sheet resistance at the back surface of the p-type silicon substrate was over 1,000,000 Ω/cm² and not measurable, which confirmed that an n-type diffusion layer was not formed. Further, it was confirmed that there was no etching residue at a region at which the n-type diffusion layer was formed.

Subsequently, occurrence of out-diffusion was evaluated by secondary ion mass spectroscopy (SIMS) in the same manner as Example 1. The phosphorus concentration was 10²¹ atoms/cm³ at the portion applied with the composition for forming an n-type diffusion layer, and the phosphorus concentration was 10¹⁷ atoms/cm³ at the point 2 mm away from the outline of the portion applied with the composition for forming an n-type diffusion layer, which was 1/10,000 of the former phosphorus concentration. The result confirmed that out-diffusion was sufficiently suppressed.

Subsequently, the composition for forming an n-type diffusion layer was dried and left under a high humidity condition, and subjected to a thermal treatment and hydrofluoric treatment, in the same manner to Example 1. Then, the sheet resistance was measured. The sheet resistance was 18 Ω/cm², which showed that the amount of diffusion of phosphorus did not change between a case in which the composition for forming an n-type diffusion layer was left under a high humidity condition after drying and a case in which the composition was not left under a high humidity condition. Further, it was confirmed that there was no etching residue.

### <Example 6>

A composition for forming an n-type diffusion layer including 0.1% of 3-acryloxypropyltrimethoxysilane as an organometallic compound was prepared in the same manner as Example 1, except that the amount of 3-acryloxypropyltrimethoxysilane was changed from 0.5 g to 0.1 g.

Subsequently, the sheet resistance was measured by the same process as Example 1. As a result, the sheet resistance at the surface of the silicon substrate, at the side at which the n-type diffusion layer was formed, was 15 Ω/cm², which confirmed that an n-type diffusion layer was formed by diffusion of P (phosphorus). The sheet resistance at the back surface of the p-type silicon substrate was over 1,000,000 Ω/cm² and not measurable, which confirmed that an n-type diffusion layer was not formed. Further, it was confirmed that there was no etching residue at a region at which the n-type diffusion layer was formed.

Subsequently, occurrence of out-diffusion was evaluated by secondary ion mass spectroscopy (SIMS) in the same manner as Example 1. The phosphorus concentration was 10²¹ atoms/cm³ at the portion applied with the composition for forming an n-type diffusion layer, and the phosphorus concentration was 10¹⁸ atoms/cm³ at the point 2 mm away from the outline of the portion applied with the composition for forming an n-type diffusion layer, which was 1/1,000 of the former phosphorus concentration. The result confirmed that out-diffusion was sufficiently suppressed.

Subsequently, the composition for forming an n-type diffusion layer was dried and left under a high humidity condition, and subjected to a thermal treatment and hydrofluoric treatment, in the same manner to Example 1. Then, the sheet resistance was measured. The sheet resistance was 17 Ω/cm², which showed that the change in the amount of diffusion of phosphorus was little between a case in which the composition for forming an n-type diffusion layer was left under a high humidity condition after drying and a case in which the composition was not left under a high humidity condition. Further, it was confirmed that there was no etching residue.

### <Example 7>

A composition for forming an n-type diffusion layer including 0.5% of tetraethoxysilane (Tokyo Chemical Industry Co., Ltd.) as an organometallic compound was prepared in the same manner as Example 1, except that 3-acryloxypropyltrimethoxysilane was replaced by the same amount of tetraethoxysilane.

Subsequently, the sheet resistance was measured by the same process as Example 1. As a result, the sheet resistance at the surface of the silicon substrate, at the side at which the n-type diffusion layer was formed, was 16 Ω/cm², which confirmed that an n-type diffusion layer was formed by diffusion of P (phosphorus). The sheet resistance at the back surface of the p-type silicon substrate was over 1,000,000 Ω/cm² and not measurable, which confirmed that an n-type diffusion layer was not formed. Further, it was confirmed that there was no etching residue at a region at which the n-type diffusion layer was formed.

Subsequently, occurrence of out-diffusion was evaluated by secondary ion mass spectroscopy (SIMS) in the same manner as Example 1. The phosphorus concentration was 10²¹ atoms/cm³ at the portion applied with the composition for forming an n-type diffusion layer, and the phosphorus concentration was 10¹⁸ atoms/cm³ at the point 2 mm away from the outline of the portion applied with the composition for forming an n-type diffusion layer, which was 1/1,000 of the former phosphorus concentration. The result confirmed that out-diffusion was sufficiently suppressed.

Subsequently, the composition for forming an n-type diffusion layer was dried and left under a high humidity condition, and subjected to a thermal treatment and hydrofluoric treatment, in the same manner to Example 1. Then, the sheet resistance was measured. The sheet resistance was 18 Ω/m², which showed that the change in the amount of diffusion of phosphorus was little between a case in which the composition for forming an n-type diffusion layer was left under a high humidity condition after drying and a case in which the composition was not left under a high humidity condition. Further, it was confirmed that there was no etching residue.

### <Example 8>

A composition for forming an n-type diffusion layer including 0.5% of methyltrimethoxysilane (KBM-13, Shin-Etsu Chemical Co., Ltd.) as an organometallic compound was prepared in the same manner as Example 1, except that 3-acryloxypropyltrimethoxysilane was replaced by the same amount of methyltrimethoxysilane.

Subsequently, the sheet resistance was measured by the same process as Example 1. As a result, the sheet resistance at the surface of the silicon substrate, at the side at which the n-type diffusion layer was formed, was 15 Ω/cm², which confirmed that an n-type diffusion layer was formed by diffusion of P (phosphorus). The sheet resistance at the back surface of the p-type silicon substrate was over 1,000,000 Ω/cm² and not measurable, which confirmed that an n-type diffusion layer was not formed. Further, it was confirmed that there was no etching residue at a region at which the n-type diffusion layer was formed.

Subsequently, occurrence of out-diffusion was evaluated by secondary ion mass spectroscopy (SIMS) in the same manner as Example 1. The phosphorus concentration was 10²¹ atoms/cm³ at the portion applied with the composition for forming an n-type diffusion layer, and the phosphorus concentration was 10¹⁸ atoms/cm³ at the point 2 mm away from the outline of the portion applied with the composition for forming an n-type diffusion layer, which was 1/1,000 of the former phosphorus concentration. The result confirmed that out-diffusion was sufficiently suppressed.

Subsequently, the composition for forming an n-type diffusion layer was dried and left under a high humidity condition, and subjected to a thermal treatment and hydrofluoric treatment, in the same manner to Example 1. Then, the sheet resistance was measured. The sheet resistance was 17 Ω/cm², which showed that the change in the amount of diffusion of phosphorus was little between a case in which the composition for forming an n-type diffusion layer was left under a high humidity condition after drying and a case in which the composition was not left under a high humidity condition. Further, it was confirmed that there was no etching residue.

### <Example 9>

A composition for forming an n-type diffusion layer including 0.5% of polydimethylsiloxane (KF-96-100cs, Shin-Etsu Chemical Co., Ltd.) as an organometallic compound was prepared in the same manner as Example 1, except that 3-acryloxypropyltrimethoxysilane was replaced by the same amount of polydimethylsiloxane.

Subsequently, the sheet resistance was measured by the same process as Example 1. As a result, the sheet resistance at the surface of the silicon substrate, at the side at which the n-type diffusion layer was formed, was 16 Ω/cm², which confirmed that an n-type diffusion layer was formed by diffusion of P (phosphorus). The sheet resistance at the back surface of the p-type silicon substrate was over 1,000,000 Ω/cm² and not measurable, which confirmed that an n-type diffusion layer was not formed. Further, it was confirmed that there was no etching residue at a region at which the n-type diffusion layer was formed.

Subsequently, occurrence of out-diffusion was evaluated by secondary ion mass spectroscopy (SIMS) in the same manner as Example 1. The phosphorus concentration was 10²¹ atoms/cm³ at the portion applied with the composition for forming an n-type diffusion layer, and the phosphorus concentration was 10¹⁸ atoms/cm³ at the point 2 mm away from the outline of the portion applied with the composition for forming an n-type diffusion layer, which was 1/1,000 of the former phosphorus concentration. The result confirmed that out-diffusion was sufficiently suppressed.

Subsequently, the composition for forming an n-type diffusion layer was dried and left under a high humidity condition, and subjected to a thermal treatment and hydrofluoric treatment, in the same manner to Example 1. Then, the sheet resistance was measured. The sheet resistance was 18 Ω/cm², which showed that the change in the amount of diffusion of phosphorus was little between a case in which the composition for forming an n-type diffusion layer was left under a high humidity condition after drying and a case in which the composition was not left under a high humidity condition. Further, it was confirmed that there was no etching residue.

### <Example 10>

A composition for forming an n-type diffusion layer including 0.5% of isopropyltriisostealoyl titanate (TTS, Ajinomoto Co., Inc.) as an organometallic compound was prepared in the same manner as Example 1, except that 3-acryloxypropyltrimethoxysilane was replaced by the same amount of isopropyltriisostealoyl titanate.

Subsequently, the sheet resistance was measured by the same process as Example 1, except that immersion in hydrofluoric acid was performed for 10 minutes. As a result, the sheet resistance at the surface of the silicon substrate, at the side at which the n-type diffusion layer was formed, was 15 Ω/cm², which confirmed that an n-type diffusion layer was formed by diffusion of P (phosphorus). The sheet resistance at the back surface of the p-type silicon substrate was over 1,000,000 Ω/cm² and not measurable, which confirmed that an n-type diffusion layer was not formed. Further, it was confirmed that there was no etching residue at a region at which the n-type diffusion layer was formed.

Subsequently, occurrence of out-diffusion was evaluated by secondary ion mass spectroscopy (SIMS) in the same manner as Example 1. The phosphorus concentration was 10²¹ atoms/cm³ at the portion applied with the composition for forming an n-type diffusion layer, and the phosphorus concentration was 10¹⁸ atoms/cm³ at the point 2 mm away from the outline of the portion applied with the composition for forming an n-type diffusion layer, which was 1/1,000 of the former phosphorus concentration. The result confirmed that out-diffusion was sufficiently suppressed.

Subsequently, the composition for forming an n-type diffusion layer was dried and left under a high humidity condition, and subjected to a thermal treatment and hydrofluoric treatment, in the same manner to Example 1. Then, the sheet resistance was measured. The sheet resistance was 17 Ω/cm², which showed that the change in the amount of diffusion of phosphorus was little between a case in which the composition for forming an n-type diffusion layer was left under a high humidity condition after drying and a case in which the composition was not left under a high humidity condition. Further, it was confirmed that there was no etching residue.

### <Example 11>

A composition for forming an n-type diffusion layer including 0.5% of hexamethyldisilazane (SZ-31, Shin-Etsu Chemical Co., Ltd.) as an organometallic compound was prepared in the same manner as Example 1, except that 3-acryloxypropyltrimethoxysilane was replaced by the same amount of hexamethyldisilazane.

Subsequently, the sheet resistance was measured by the same process as Example 1. As a result, the sheet resistance at the surface of the silicon substrate, at the side at which the n-type diffusion layer was formed, was 16 Ω/cm², which confirmed that an n-type diffusion layer was formed by diffusion of P (phosphorus). The sheet resistance at the back surface of the p-type silicon substrate was over 1,000,000 Ω/cm² and not measurable, which confirmed that an n-type diffusion layer was not formed. Further, it was confirmed that there was no etching residue at a region at which the n-type diffusion layer was formed.

Subsequently, occurrence of out-diffusion was evaluated by secondary ion mass spectroscopy (SIMS) in the same manner as Example 1. The phosphorus concentration was 10²¹ atoms/cm³ at the portion applied with the composition for forming an n-type diffusion layer, and the phosphorus concentration was 10¹⁸ atoms/cm³ at the point 2 mm away from the outline of the portion applied with the composition for forming an n-type diffusion layer, which was 1/1,000 of the former phosphorus concentration. The result confirmed that out-diffusion was sufficiently suppressed.

Subsequently, the composition for forming an n-type diffusion layer was dried and left under a high humidity condition, and subjected to a thermal treatment and hydrofluoric treatment, in the same manner to Example 1. Then, the sheet resistance was measured. The sheet resistance was 18 Ω/cm², which showed that the change in the amount of diffusion of phosphorus was little between a case in which the composition for forming an n-type diffusion layer was left under a high humidity condition after drying and a case in which the composition was not left under a high humidity condition. Further, it was confirmed that there was no etching residue.

### <Comparative Example 1>

A composition for forming an n-type diffusion layer was prepared in the same manner as Example 1, except that 3-acryloxypropyltrimethoxysilane was not added.

Subsequently, the sheet resistance was measured by the same process as Example 1. As a result, the sheet resistance at the surface of the silicon substrate, at the side at which the n-type diffusion layer was formed, was 15 Ω/cm², which confirmed that an n-type diffusion layer was formed by diffusion of P (phosphorus). The sheet resistance at the back surface of the p-type silicon substrate was over 1,000,000 Ω/cm² and not measurable, which confirmed that an n-type diffusion layer was not formed. Further, it was confirmed that there was no etching residue at a region at which the n-type diffusion layer was formed.

Subsequently, occurrence of out-diffusion was evaluated by secondary ion mass spectroscopy (SIMS) in the same manner as Example 1. The phosphorus concentration was 10²¹ atoms/cm³ at the portion applied with the composition for forming an n-type diffusion layer, and the phosphorus concentration was 10¹⁷ atoms/cm³ at the point 2 mm away from the outline of the portion applied with the composition for forming an n-type diffusion layer, which was 1/10,000 of the former phosphorus concentration. The result confirmed that out-diffusion was sufficiently suppressed.

Subsequently, the composition for forming an n-type diffusion layer was dried and left under a high humidity condition, and subjected to a thermal treatment and hydrofluoric treatment, in the same manner to Example 1. Then, the sheet resistance was measured.

The sheet resistance was 20 Ω/cm², which showed that there was a change in the amount of diffusion of phosphorus between a case in which the composition for forming an n-type diffusion layer was left under a high humidity condition after drying and a case in which the composition was not left under a high humidity condition. The sheet resistance at the back surface was 10,000 Ω/cm², which showed that an n-type diffusion layer was formed although at a slight degree.

Further, as a result of secondary ion mass spectroscopy (SIMS), the phosphorus concentration was 10²¹ atoms/cm³ at the portion applied with the composition for forming an n-type diffusion layer, whereas the phosphorus concentration was 10¹⁹ atoms/cm³ at the point 2 mm away from the outline of the portion applied with the composition for forming an n-type diffusion layer, which was 1/100 of the former phosphorus concentration. The result confirmed that out-diffusion was caused at a slight degree.

### <Comparative Example 2>

A composition for forming an n-type diffusion layer was prepared in the same manner as Example 1, except that the P₂O₅-SiO₂-MgO glass was replaced with the same amount of ammonium dihydrogenphosphate.

Subsequently, the same processes as Example 1 were conducted and the sheet resistance was measured. As a result, the sheet resistance at the surface of the p-type silicon substrate, at the side at which the n-type diffusion layer was formed, was 25 Ω/cm², which confirmed that an n-type diffusion layer was formed by diffusion of P (phosphorus). The sheet resistance at the back surface of the p-type silicon substrate was over 50 Ω/cm², which confirmed that an n-type diffusion layer was formed also at the back surface. Further, existence of etching residue was confirmed at a region at which the n-type diffusion layer was formed.

Subsequently, occurrence of out-diffusion was evaluated by secondary ion mass spectroscopy (SIMS) in the same manner as Example 1. The phosphorus concentration was 10²¹ atoms/cm³, both at the portion applied with the composition for forming an n-type diffusion layer and at the point 2 mm away from the outline of the portion applied with the composition for forming an n-type diffusion layer. The result confirmed the occurrence of out-diffusion.

## Claims

1. A composition for forming an n-type diffusion layer, comprising: glass particles that comprise a donor element; a dispersing medium; and an organometallic compound.

2. The composition for forming an n-type diffusion layer according to claim 1, wherein the organometallic compound comprises a silicon atom.

3. The composition for forming an n-type diffusion layer according to claim 1 or claim 2, wherein the organometallic compound comprises at least one selected from the group consisting of a metal alkoxide, a silicone resin and an alkylsilazane compound.

4. The composition for forming an n-type diffusion layer according to any one of claims 1 to 3, wherein the organometallic compound comprises a metal alkoxide, and the metal alkoxide comprises a silicon alkoxide.

5. The composition for forming an n-type diffusion layer according to any one of claims 1 to 4, wherein the organometallic compound comprises a metal alkoxide, and the metal alkoxide comprises a silane coupling agent.

6. The composition for forming an n-type diffusion layer according to claim 1 or claim 2, wherein the organometallic compound comprises a silicone resin.

7. The composition for forming an n-type diffusion layer according to claim 6, wherein the silicone resin comprises dimethyl polysiloxane.

8. The composition for forming an n-type diffusion layer according to claim 1 or claim 2, wherein the organometallic compound comprises an alkylsilazane compound.

9. The composition for forming an n-type diffusion layer according to any one of claims 1 to 8, wherein the donor element is at least one selected from the group consisting of P (phosphorus) and Sb (antimony).

10. The composition for forming an n-type diffusion layer according to any one of claims 1 to 9, wherein the glass particles comprise at least one donor element-containing substance selected from the group consisting of P₂O₃, P₂O₅ and Sb₂O₃, and at least one glass component substance selected from the group consisting of SiO₂, K₂O, Na₂O, Li₂O, BaO, SrO, CaO, MgO, BeO, ZnO, PbO, CdO, V₂O₅, SnO, ZrO₂ and MoO₃.

11. A method of forming an n-type diffusion layer, the method comprising a process of applying the composition for forming an n-type diffusion layer according to any one of claims 1 to 10 onto a semiconductor substrate, and a process of thermally treating the semiconductor substrate applied with the composition for forming an-type diffusion layer.

12. A method of producing a semiconductor substrate with an n-type diffusion layer, the method comprising a process of applying the composition for forming an n-type diffusion layer according to any one of claims 1 to 10 onto a semiconductor substrate, and a process of forming an n-type diffusion layer by thermally treating the semiconductor substrate applied with the composition for forming an n-type diffusion layer.

13. A method of producing a photovoltaic cell element, the method comprising a process of applying the composition for forming an n-type diffusion layer according to any one of claims 1 to 10 onto a semiconductor substrate, a process of forming an n-type diffusion layer by thermally treating the semiconductor substrate applied with the composition for forming an n-type diffusion layer, and a process of forming an electrode on the n-type diffusion layer.
